# EUROPEAN PATENT SPECIFICATION

(11) **EP 0 360 998 B1**
(45) Date of publication and mention of the grant of the patent: **29.12.1993**
(21) Application number: 89113245.8
(22) Date of filing: 19.07.1989
(51) Int. Cl.: H01L 29/06, H01L 29/784

(54) **Semiconductor device having improved element isolation area**
Halbleiteranordnung mit verbesserter Elementisolierungsfläche
Dispositif semi-conducteur dont la surface d'isolation des éléments est modifiée

(30) Priority: 27.09.1988 JP 241501/88
(43) Date of publication of application: 04.04.1990
(73) Proprietor: KABUSHIKI KAISHA TOSHIBA, Kawasaki-shi, Kanagawa-ken 210 (JP)
(72) Inventor: Arai, Takashi c/o Intellectual Property Division, Minato-ku Tokyo 105 (JP); Inada, Nakafumi c/o Intellectual Property Division, Minato-ku Tokyo 105 (JP); Takahashi, Tsutomu Intellectual Property Division, Minato-ku Tokyo 105 (JP)
(74) Representative: Lehn, Werner, Dipl.-Ing.

(56) References cited:
- EP-A- 0 127 142
- FR-A- 2 056 969
- GB-A- 1 131 675

## Description

The present invention relates to a semiconductor device and, more particularly, to a semiconductor device including high voltage withstand transistors with an improved element isolation area for used for a high voltage withstand section of a large LC (liquid crystal) driver type LSI.

A guard ring system has so far been employed as a technique for forming an element isolation area in a high voltage withstand transistor.

In a high voltage withstand transistor, for example, a polysilicon connection layer which is the electrode of that transistor is formed in contact with drain and source regions formed in the upper surface portion of a semiconductor substrate. A field oxide film is formed around the drain and source regions and a guard ring is formed around the field oxide film and has a predetermined impurity concentration.

In the arrangement of the high voltage withstand transistor, the polysilicon connection layer providing the electrodes of the transistor is situated over the guard ring in an intersecting way. For the guard ring of a p-type (n-type), for example, the guard ring portion which is situated just over that polysilicon connection layer is inverted to an n-type (p-type) at about 10V.

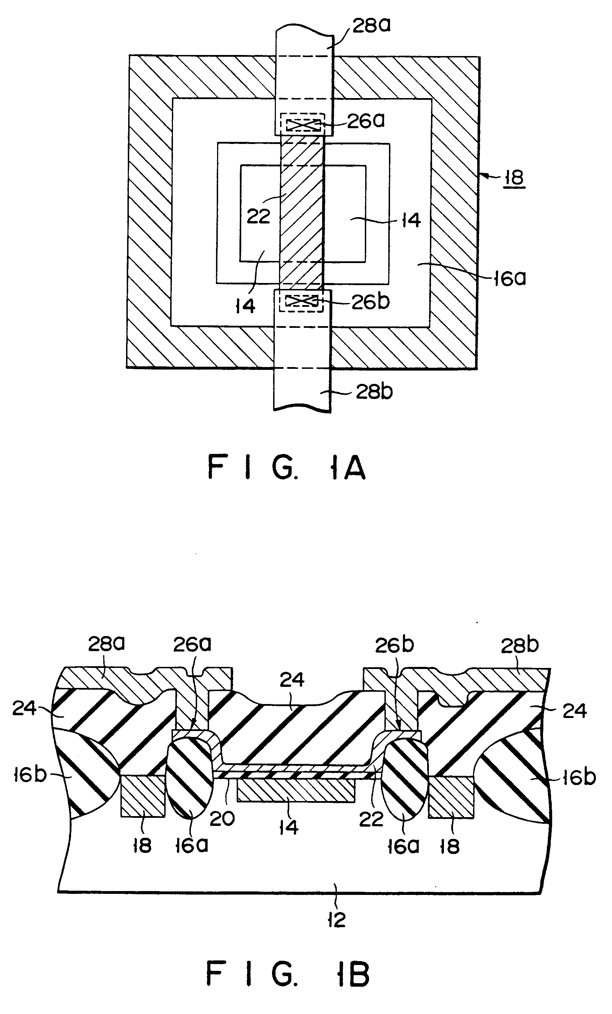

Therefore, a device whose withstand voltage exceeding 30V is usually of such a type as shown in Fig. 1A and 1B. Fig. 1A is a plan view showing an array pattern of a high voltage withstand transistor of the prior art and Fig. 1B is a cross-sectional view showing a transistor of Fig. 1A.

In Figs. 1A and 1B, a drain/source area 14 is formed in the upper surface portion of a semiconductor substrate 12 and a field oxide film 16a of about (10000 Å) 1 µm in thickness is formed around the drain/source area 14 at a predetermined interval. A guard ring 18 is formed around the field oxide film 16a such that it is situated near the field oxide film 16b. On that portion of the upper surface of the substrate 12, including the surface portion of the drain/source area 14, which is surrounded with the field oxide film 16a, a gate oxide film 20 is formed as an insulating film. A polysilicon connection layer 22 is formed on the gate oxide film 20 and field oxide film 16a. A field oxide film 24 is formed on the polysilicon connection layer 22, field oxide film 16b and guard ring 18. Aluminum interconnection layers 28a and 28b are connected respectively via contact areas 26a and 26b to the polysilicon connection layer 22 just over the field oxide film 16a. In order to highly make an inversion threshold voltage of the guard ring 18 high, the aluminum interconnection layers 28a and 28b are patterned after the field oxide films 16a, 16b and 24 have been formed.

In the conventional high voltage withstand transistor thus arranged, it is possible to raise the withstand voltage if the guard ring 18 is employed as element isolation for the high voltage withstand transistor.

However, the aluminum interconnection layers 28a and 28b are used at an intersecting location of the guard ring 18, requiring contact areas 26a and 26b between the polysilicon connection layer 22 and the aluminum interconnection layers 28a and 28b. Thus the field oxide layer is necessary for the formation of the contact areas 26a and 26b, unavoidably leading to an increase in the chip size of the transistor and hence, to a cost problem.

FR-A-2 056 969 describes an insulated gate semiconductor device having a source region and a drain region in a semiconductor substrate, a conductive channel formed by an inversion layer in the substrate between those two regions and an insulated gate electrode for controlling the conductivity of the conductive channel, a channel stopper comprising a high concentration region of a conductivity type the same as that of the substrate being formed adjacent to the end portions of said source and drain regions so as to close the end portions thereof, said channel stopper being arranged to be spaced from said two regions and to cross under said gate electrode at both end portions of said gate electrode interposing an insulating film therebetween.

In EP-A-0 127 142 a semiconductor device is described including a p-channel MOS transistor formed in an element region of an n-type semiconductor substrate. N⁺⁺-type thin surface layers are formed in the field regions of the semiconductor substrate. The first layers are formed such that portions thereof in the vicinity of the surface of the substrate respectively have an impurity concentration peak to prevent inversion of the conductivity type of the surface of the substrate. N⁺-type thick second surface layers are formed to underlay the first surface layers respectively. The second surface layers have a higher impurity concentration than that of the semiconductor substrate and a lower impurity concentration than that of the first surface layers, so that the punchthrough phenomenon between parasitic MOS transistors can be prevented.

It is accordingly, the object of the present invention to provide a semiconductor device which can reduce a chip size without lowering a withstand voltage.

According to the present invention, there is provided a semiconductor device comprising:
a semiconductor device comprising a semiconductor substrate of a predetermined conductive type and a first impurity concentration, source and drain regions formed in an upper surface portion of said semiconductor substrate and having an exposed surface, guard ring means provided on a portion surrounding said source and drain regions so as to have an exposed surface, said guard ring means being of the same conductive type as said semiconductor substrate and having a second impurity concentration greater than the first impurity concentration of said semiconductor substrate, a gate insulating film formed on said source and drain regions and said guard ring means and having a predetermined film thickness and an interconnection layer formed on said gate insulating film so as to intersect with said guard ring means, said guard ring means having a first portion having the second impurity concentration greater than the first impurity concentration of said semiconductor substrate, and at least one second portion used for supplying a high inversion threshold voltage and having a third impurity concentration greater than that of said first portion, said gate insulating film including a central portion having a first thickness and overlaying a portion of said exposed surface of said source and drain regions so as to be in contact therewith and end portions having a second thickness larger than said first thickness and covering said exposed surface of said second portions of said guard ring means so as to be in contact therewith, and said interconnection layer being formed on said gate insulating film and intersects with said at least one second portion of said guard ring means, with the end portions of said gate insulating film interposed.

This invention can be more fully understood from the following detailed description when taken in conjunction with the accompanying drawings, in which:
These and other features and advantages of the present invention will become more apparent from the following detailed description of an exemplary embodiment as illustrated in the accompanying drawings in which:
Figs. 1A and 1B are a plan view and cross-sectional view, respectively, showing a high voltage withstand transistor according to a conventional semiconductor device;
Figs. 2A and 2B show a semiconductor device according to one embodiment of the present invention; Fig. 2A being a plan view showing a pattern of a high voltage withstand transistor and Fig. 2B being a cross-sectional view as taken along line I-I in Fig. 2A; and
Fig. 3 shows a withstand voltage characteristic curve of the high withstand voltage transistor of the present invention.

The embodiment of the present invention will be explained below with reference to the accompanying drawings.

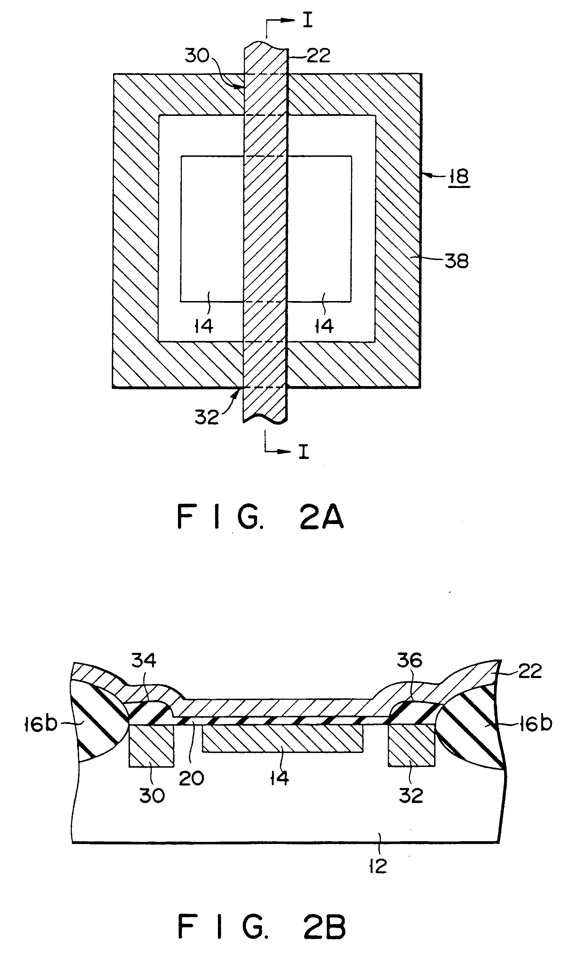

Figs. 2A and 2B show an arrangement of a high voltage withstand transistor according to one embodiment of the present invention, Fig. 2A being a plan view showing a pattern of the transistor and Fig. 2B being a cross-sectional view, as taken along line I-I in Fig. 2A. Like reference numerals are employed in this embodiment by attaching like reference numerals to elements corresponding to those in Fig. 1.

A drain/source area 14 is formed in the upper surface portion of a semiconductor substrate 12 and a guard ring 18 is formed outside the drain/source area 14 with a predetermined spacing left therebetween. A field oxide film 16b is formed outside the guard ring 18.

On the upper surface portion of the semiconductor substrate 12 including the intersecting portions of guard ring portions 30, 32 as will be set forth in more detail below, and on the drain/source areas 14, a gate oxide film 20 is formed as an insulating film. The gate oxide film 20 is, for example, 70 nm (700 Å) thick at a location between the guard ring portions 30, 32 and 200 nm (2000 Å) thick at the gate oxide film intersecting portions 34,36 adjacent to the intersecting portions of the guard ring portions 30, 32. On the gate oxide film 20 and field oxide film 16b, a polysilicon connection layer 22 is formed as an electrode.

The guard ring 18 surrounds the outside of the drain/source area 14 relative to the substrate 12 and has its impurity concentration locally varied and hence is not fixed in its impurity concentration. That is, the guard ring portions 30, 32 just below that portion of the gate oxide film intersecting portions 34, 36 intersecting the polysilicon connection layer 22 are set to be higher in impurity concentration than the rest (the remaining portion) 38 of the guard ring 18. In order to raise the concentration of the aforementioned guard ring portions 30, 32, more impurity is implanted there than the remaining portion 38 of the guard ring 18.

Here in order not to increase a diffusion depth xⱼ due to an increase in the coefficient of impurity diffusion into the silicon, the aforementioned concentration level is predetermined. In the aforementioned embodiment, the guard ring portions 30, 32 as set forth above have their impurity concentration raised by BF₂ for a P type and As for an N type. For example, the impurity concentration of the guard ring portions 30, 32 as set forth above is 1 × 10²⁰ cm⁻³ and that of said remaining portion of the guard ring 18 is 1 × 10¹⁷ cm⁻³.

In order to prevent a possible crystal defect in an ion implantation step and a possible out-diffusion in a subsequent oxidation step, an ion implantation is carried out through an ion passage through a silicon oxide film (SiO₂). On the other hand, as the guard ring portions 30, 32 as set forth above are thicker, that is 70 nm (700 Å), an impurity ion cannot be implanted into silicon through a passage through an oxide film. Thus, the aforementioned ion implantation step is conducted via the 10 nm (100 Å) thick oxide film by a step called a dummy oxidation film step. By so doing, the guard ring portions 30,32 of the guard ring 18 become very useful in terms of an increased inversion threshold voltage and an enhanced reliability.

The gate oxide film intersecting portions 34, 36 of the gate oxide film 20 are made thick compared with the rest of the gate oxide film 20. That is, the guard ring portions 30, 32 intersecting with the polysilicon connection layer 22 have their thickness increased by their own particular photoetching step, for example, from ordinary 70 to 200 nm (700 Å to 2000 Å). By so doing, the inversion threshold voltage of the guard ring portion 30,32 is increased without varying the characteristic of the high voltage withstand transistor.

Of the guard ring 18, only the guard ring portions 30, 32 have their impurity increased and the remaining portion 38 of the guard ring 18 is low in impurity relative to the guard ring portions 30, 32. It is, therefore, possible to, at a heat-treating step following the step of forming the impurity-increased guard ring portions, prevent unwanted impurity diffusion to a minimum possible extent and hence prevent an adverse effect which might otherwise occur by that diffusion step.

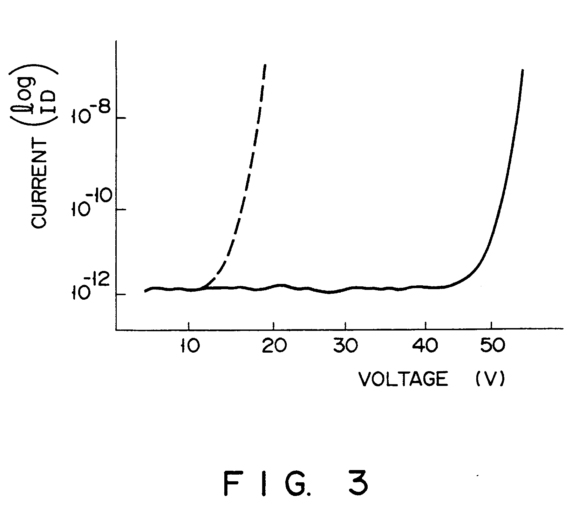

Fig. 3 is a characteristic curve representing the voltage withstand characteristic of the high voltage withstand transistor according to the embodiment of the present invention. In the graph of Fig. 3, the ordinate shows a dissipation current at the turn-OFF time of the transistor as set forth above and the abscissa shows a voltage which is applied to that transistor.

In the graph of Fig. 3, the characteristic curve as indicated by the dotted line shows a case of a basic high voltage withstand transistor with a gate oxide film of a uniform thickness and with the impurity concentration of the guard ring kept constant. From this graph it will be seen that the withstand voltage of the transistor is about 15 V. The high voltage withstand transistor according to the embodiment of the present invention has a characteristic curve as indicated by the solid line in Fig. 3. From this graph it will be appreciated that the withstand voltage of the present transistor is about 45 to 50 V as a limit. In this case, it is possible to improve the voltage withstand characteristic of the present invention by a factor of three.

Since the embodiment of the present invention obviates the necessity for providing a contact between the polysilicon connection layer and the aluminum interconnection layer as in the prior art, it is possible to reduce a requisite occupation area. Furtheremore the present invention can eliminate the need for providing the field oxide film inside the guard ring, thus achieving a high packing density with a smaller requisite area.

Reference signs in the claims are intended for better understanding and shall not limit the scope.

## Claims

1. A semiconductor device comprising a semiconductor substrate (12) of a predetermined conductive type and a first impurity concentration, source and drain regions (14) formed in an upper surface portion of said semiconductor substrate (12) and having an exposed surface, guard ring means (18) provided on a portion surrounding said source and drain regions (14) so as to have an exposed surface, said guard ring means (18) being of the same conductive type as said semiconductor substrate (12) and having a second impurity concentration greater than the first impurity concentration of said semiconductor substrate (12), a gate insulating film (20) formed on said source and drain regions (14) and said guard ring means (18) and having a predetermined film thickness and an interconnection layer (22) formed on said gate insulating film (20) so as to intersect with said guard ring means,
said guard ring means (18) having a first portion (38) having the second impurity concentration greater than the first impurity concentration of said semiconductor substrate (12), and at least one second portion (30,32) used for supplying a high inversion threshold voltage and having a third impurity concentration greater than that of said first portion (38),
said gate insulating film (20) including a central portion having a first thickness and overlaying a portion of said exposed surface of said source and drain regions (14) so as to be in contact therewith and end portions having a second thickness larger than said first thickness and covering said exposed surface of said second portions (30,32) of said guard ring means (18) so as to be in contact therewith, and
said interconnection layer (22) being formed on said gate insulating film and intersects with said at least one second portion (30,32) of said guard ring means (18), with the end portions of said gate insulating film (20) interposed.

2. A semiconductor device according to claim 1,
wherein said guard ring means (18) has a plurality of second portions (30,32), the number of which is determined by the number of locations where said interconnection layer (22) intersects with said guard ring means (18).

## Patentansprüche

1. Halbleitereinrichtung umfassend ein Halbleitersubstrat (12) eines vorgegebenen Leitfähigkeitstyps und einer ersten Verunreinigungskonzentration, Source- und Drainbereiche (14), die in einem oberen Oberflächenabschnitt des Halbleitersubstrats (12) gebildet sind und eine freiliegende Oberfläche aufweisen, eine Schutzring-Einrichtung (18), die auf einem die Source- und Drainbereiche (14) umgebenden Abschnitt vorgesehen ist, so daß sie eine freiliegende Oberfläche aufweist, wobei die Schutzring-Einrichtung (18) von dem gleichen Leitfähigkeitstyp wie das Halbleitersubstrat (12) ist und eine zweite Verunreinigungskonzentration aufweist, die größer ist als die erste Verunreinigungskonzentration des Halbleitersubstrats (12), einen Gate-Isolationsfilm (20), der auf den Source- und Drainbereichen (14) und der Schutzring-Einrichtung (18) gebildet ist und eine vorgegebene Filmdicke aufweist, und eine Zwischenverbindungsschicht (22), die auf dem Gate-Isolationsfilm (20) so gebildet ist, daß sie die Schutzring-Einrichtung schneidet,
wobei die Schutzring-Einrichtung (18) einen ersten Abschnitt (38) aufweist, der die zweite Verunreinigungskonzentration größer als die erste Verunreinigungskonzentration des Halbleitersubstrats (12) aufweist, und wenigstens einen zweiten Abschnitt (30, 32), der zum Zuführen einer hohen Inversions-Schwellspannung verwendet wird und eine dritte Verunreinigungskonzentration größer als diejenige des ersten Abschnitts (38) aufweist,
wobei der Gate-Isolationsfilm (20) einen Zentralabschnitt umfaßt, der eine erste Dicke aufweist und mit einem Abschnitt der freiliegenden Oberfläche der Source- und Drainbereiche (14) so überlappt, daß er in Kontakt damit ist und Endabschnitte, die eine zweite Dicke größer als die erste Dicke aufweisen und die freiliegende Oberfläche der zweiten Abschnitte (30, 32) der Schutzring-Einrichtung (18) so bedecken, daß sie damit in Kontakt sind, und
wobei die Zwischenverbindungsschicht (22) auf dem Gate-Isolationsfilm gebildet ist und den wenigstens einen zweiten Abschnitt (30, 32) der Schutzring-Einrichtung (18) schneidet, wobei die Endabschnitte des Gate-Isolationsfilms (20) dazwischenliegen.

2. Halbleitereinrichtung nach Anspruch 1,
dadurch **gekennzeichnet,** daß die Schutzring-Einrichtung (18) eine Vielzahl von zweiten Abschnitten (30,32) aufweist, deren Anzahl durch die Anzahl der Stellen bestimmt ist, an denen die Zwischenverbindungsschicht (22) die Schutzring-Einrichtung (18) schneidet.

## Revendications

1. Dispositif à semiconducteur comprenant un substrat semiconducteur (12) d'un type de conductivité prédéterminé et d'une première concentration d'impuretés, des régions de source et de drain (14) formées dans une partie de surface supérieure dudit substrat semiconducteur (12) et comportant une surface mise à nu, un moyen d'anneau de garde (18) prévu sur une partie entourant lesdites régions de source et de drain (14) de manière à disposer d'une surface mise à nu, ledit moyen d'anneau de garde (18) étant du même type de conductivité que ledit substrat semiconducteur (12) et présentant une seconde concentration d'impuretés supérieure à la première concentration d'impuretés dudit substrat semiconducteur (12), un film d'isolation de grille (20) formé sur lesdites régions de source et de drain (14) et sur ledit moyen d'anneau de garde (18) et présentant une épaisseur de film prédéterminée et une couche d'interconnexion (22) formée sur ledit film d'isolation de grille (20) de manière à intersecter ledit moyen d'anneau de garde,
ledit moyen d'anneau de garde (18) comportant une première partie (38) présentant la seconde concentration d'impuretés supérieure à la première concentration d'impuretés dudit substrat semiconducteur (12) et au moins une seconde partie (30, 32) utilisée pour appliquer une tension de seuil d'inversion élevée et présentant une troisième concentration d'impuretés supérieure à celle de ladite première partie (38),
ledit film d'isolation de grille (20) incluant une partie centrale présentant une première épaisseur et chevauchant une partie de ladite surface mise à nu desdites régions de source et de drain (14) de manière à être en contact avec et des parties d'extrémité présentant une seconde épaisseur supérieure à ladite première épaisseur et recouvrant ladite surface mise à nu desdites secondes parties (30, 32) dudit moyen d'anneau de garde (18) de manière à être en contact avec ; et
ladite couche d'interconnexion (22) étant formée sur ledit film d'isolation de grille et intersectant ladite au moins une seconde partie (30, 32) dudit moyen d'anneau de garde (18), les parties d'extrémité dudit film d'isolation de grille (20) étant interposées.

2. Dispositif à semiconducteur selon la revendication 1, dans lequel ledit moyen d'anneau de garde (18) comporte une pluralité de secondes parties (30, 32) dont le nombre est déterminé par le nombre d'emplacements où ladite couche d'interconnexion (22) intersecte ledit moyen d'anneau de garde (18).
